# EUROPÄISCHE PATENTANMELDUNG

(11) **EP 0 571 863 A1**
(43) Veröffentlichungstag der Anmeldung: **01.12.1993**
(21) Anmeldenummer: 93108021.2
(22) Anmeldetag: 17.05.1993
(51) Int. Cl.: H05K 7/20, H01L 23/42, H01L 23/495, H01L 21/60, H05K 3/32

(54) **Einbausystem für auf Leiterplatten montierte, hochintegrierte, gehäuselose Bausteine**

(30) Priorität: 27.05.1992 DE 4217597
(71) Anmelder: Siemens Nixdorf Informationssysteme Aktiengesellschaft, D-33102 Paderborn (DE)
(72) Erfinder: Bachl, Johann, W-8000 München 19 (DE)
(74) Vertreter: Fuchs, Franz-Josef, Dr.-Ing.

(57) **Zusammenfassung**

Die Erfindung bezieht sich auf ein Einbausystem für auf Leiterplatten montierte, hochintegrierte, gehäuselose Bausteine. Bei LSI-Bausteinen mit einer Pinzahl > 500 und einer Verlustleistung > 50 Watt, ist eine genügend Wärmeableitung, verursacht durch die hohe Verlustleistung, durch eine einfache herkömmliche Wärmesenke nicht mehr im ausreichendem Maße gegeben. Außerdem wird durch die steigende Zahl der Anschlüsse auch die Kontaktierung der Bauelemente mit der Leiterplatte immer schwieriger. Die Erfindung löst dieses Problem dadurch, daß die Bausteine (4) mit einer Trägerplatte (6) kontaktiert sind und diese über einen ersten Spider (7) mit den zugehörigen Lötflecken auf der Leiterplatte (9) verbunden sind. Auf der Bausteinoberfläche ist eine gut wärmeleitende Membran (2), die allseits über die Bausteinkanten vorsteht und auf an der Trägerplatte (6) angebrachten Haltemitteln aufliegt und so einen Hohlraum (10) rund um den Baustein (4) bildet, befestigt. Die Membran liegt ihrerseits an einer Kühlplatte (1) an und der Hohlraum ist mit einer leicht verdampfenden Kühlflüssigkeit gefüllt. Dadurch wird eine gute Wärmeaufspreizung und Kühlwirkung und eine leichte Montierbarkeit derartiger Bausteine auf Leiterplatten erreicht.

## Beschreibung

Die Erfindung betrifft ein Einbausystem für auf Leiterplatten montierte, hochintegrierte, gehäuselose Bausteine.

Bei hochintegrierten Bausteinen mit einer Pinzahl > 500 und einer Verlustleistung > 50 Watt fällt pro Flächeneinheit eine erhebliche Wärmemenge an.

Aufgabe der vorliegenden Erfindung ist es daher, ein Einbausystem für auf Leiterplatten montierte, hochintegrierte, gehäuselose Bausteine mit optimaler Wärmeableitung zu schaffen.

Zur Lösung dieser Aufgabe sieht die Erfindung vor, daß die Bausteine mit einer Trägerplatte kontaktiert sind und diese über einen ersten Spider mit den zugehörigen Lötflecken auf der Leiterplatte verbunden sind, und daß mit einer auf der Bausteinoberfläche gut wärmeleitend befestigten, allseits über die Bausteinkanten vorstehenden Membran, die ihrerseits an einer Kühlplatte anliegt, ein Hohlraum rund um den Baustein gebildet ist, der mit einer Kühlflüssigkeit gefüllt ist.

Das Einbausystem kann insbesondere so ausgebildet sein, daß auf der Oberseite der Trägerplatte ein nach den Rändern zu aufgefächerter zweiter Spider aufgebracht ist, auf dessen Innenkontakten die Kontaktnocken des Bausteins unmittelbar aufgelötet sind und mit dessen Außenkontakten der erste Spider kontaktiert ist, daß in einem vorgegebenen Abstand rund um den Baustein auf der Trägerplatte ein geschlossener Haltesteg aufgebracht ist, auf den die Membran flüssigkeitsdicht befestigt ist, so daß sich zwischen Haltesteg und Baustein der Hohlraum bildet und daß zwischen Trägerplatte und Leiterplatte elastische Druckstücke angeordnet sind.

Der besondere Vorteil dieser Ausführung liegt in der ausgiebigen Bausteinkühlung und der guten Anlötbarkeit der Trägerplatte an die Leiterplatte.

Bei einer anderen Ausführungsform ist vorgesehen, daß die Trägerplatte als Rahmen um den Baustein ausgebildet ist, auf dessen Unterseite ein dritter Spider aufgebracht ist, daß in der Rahmenöffnung das Bauelement liegt, dessen Kontaktnocken über Bonddrähte mit den einen Enden des dritten Spiders verbunden sind, dessen andere Enden mit dem ersten Spider kontaktiert sind, daß der Zwischenraum zwischen Bauelement und rahmenförmiger Trägerplatte flüssigkeitsdicht abgedichtet ist, daß die Membran an der Außenkante des Rahmens flüssigkeitsdicht befestigt ist, so daß sich zwischen Membran, Bausteinkanten und Rahmen der Hohlraum bildet und daß zwischen Bausteinunterseite und Leiterplatte elastische Druckstücke angeordnet sind.

Sehr günstig sind bei dieser Lösung die einfachen Innen- und Außenbondverbindungen neben der ebenfalls guten Kühlwirkung durch die Flüssigkeitskühlung.

Vorteilhafterweise kann die Trägerplatte aus Keramik bestehen.

Zwischen Baustein und Trägerplatte kann zur Verbesserung der Wärmeabfuhr eine Kühlfolie eingelegt sein.

Verwendet man eine Kühlflüssigkeit mit niedrigem Siedepunkt, so kann durch auftretende Siede/Kondenskühlung ein zusätzlicher Kühleffekt erreicht werden.

Anhand der Ausführungsbeispiele nach den Figuren 1 bis 4 wird die Erfindung näher erläutert. Es zeigen
Figur 1 eine erste Ausführungsform der Erfindung,
Figur 2 eine Einzelheit bei A nach Figur 1,
Figur 3 eine Einzelheit bei B nach Figur 1 und
Figur 4 eine zweite Ausführungsform nach der Erfindung.

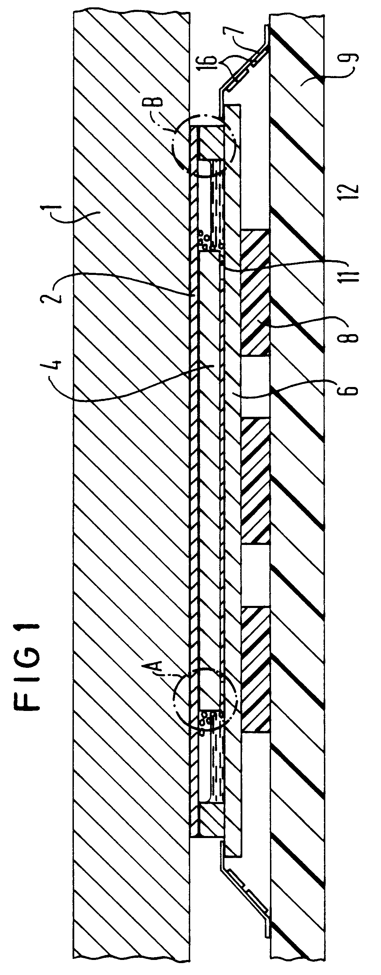

Bei der Anordnung nach Figur 1 ist der Baustein 4 mit seinen Kontaktnocken 11 unmittelbar auf die Trägerplatte 4 aufgelötet (Flip-Chip-Technik). Die enge Spiderteilung des Bausteins von ungefähr 100mµ wird mittels des zweiten Spiders 12, der auf die Trägerplatte 6 aufgebracht ist, durch eine Auffächerung nach den Rändern der Trägerplatte hin um mindestens 50 % aufgeweitet. Die Verbindung der Leiterplatte 9 mit der Trägerplatte 6 erfolgt über einen ersten Spider, der weil kein Schrägziehungsbereich erforderlich ist, eine einfache Form aufweist. Er kann eine Spiderteilung > 150mµ haben. Versteifungsstege 16, die vom Spiderträgermaterial stehengelassen werden, um den Spider später exakt mit den Lötflecken auf der Leiterplatte kontaktieren zu können, können bis dicht an die Bondungen heran angebracht werden. Auf dem Baustein 4 ist außerdem die Membrane 2, die rundum über den Baustein vorsteht, aufgeklebt oder weich aufgelötet. Die Druckstücke 8 zwischen der Trägerplatte 6 und der Leiterplatte 7 sorgen für einen innigen Kontakt der Membran 2 mit der über ihr befindlichen Kühlplatte 1. Der Baustein 4 kann auch Wärme an die Trägerplatte über die Kühlfolie 5, die zwischen beiden angeordnet ist, abführen. Mit dem auf der Trägerplatte 6 auflaminierten Haltesteg 3 aus Keramik und der auf ihn aufgelöteten Membran 2 werden abgeschlossene mit Kühlflüssigkeit gefüllte Hohlräume 10 rings um den Baustein geschaffen, die zusätzlich Wärme über eine Siede- bzw. Kondenskühlung abgeben, wenn diese Hohlräume mit einer leicht verdampfenden Kühlflüssigkeit gefüllt sind. Damit wird der wärmeabführende Bereich vom Baustein weg stark aufgefächert.

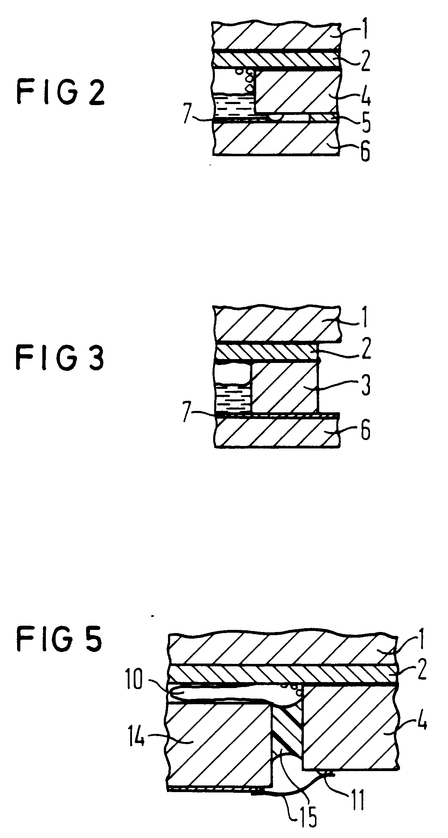

Die Figur 2 zeigt eine Einzelheit an der Stelle A in Figur 1 und die Figur 3 eine Einzelheit an der Stelle B in Figur 2 in vergrößertem Maßstab.

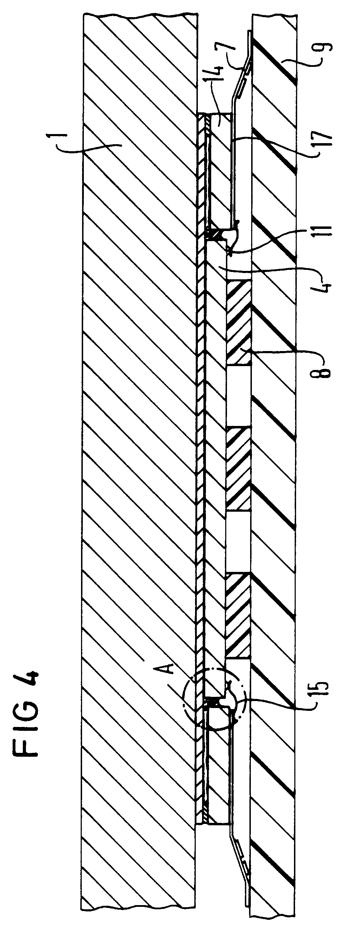

Bei der Anordnung nach Figur 4 hat die vorzugsweise aus Keramik, wie z.B. AlN bestehende Trägerplatte 14 eine Rahmenform. In der Rahmenöffnung liegt der Baustein 4, so daß die Innenkontaktierung über Bonddrähte 11 mit dem nunmehr auf der Unterseite der Trägerplatte 14 aufgebrachten, zu den Rändern hin aufgefächerten dritten Spider 14 erfolgen kann. Der aufgeweitete Anschlußbereich dieses dritten Spiders 17 wird dann über den ersten Spider 7 zu den Lötflecken (Pads) auf der Leiterplatte 9 geleitet. Durch die Druckstücke 8 wird der Baustein 4 gegen die Membran 2, die wieder auf der Bauteiloberfläche aufgeleimt oder weich aufgelötet ist und die Membran 2 wiederum gegen die Kühlplatte 1 gedrückt, um die Wärmeleitung zu verbessern. Der Baustein 4 ist zur Trägerplatte 14 hin abgedichtet.

Eine Detaildarstellung dieser Abdichtung zwischen Trägerplatte und Baustein (Einzelheit A in Figur 4) ist in Figur 5 vergrößert dargestellt. Dort ist auch deutlich der Hohlraum 10 erkennbar, der mit einer leicht verdampfenden Kühlflüssigkeit gefüllt ist, wodurch ein Kondens-/Siedekühlungseffekt erreicht wird.

## Patentansprüche

1. Einbausystem für auf Leiterplatten montierte, hochintegrierte, gehäuselose Bausteine, bei dem die Bausteine mit einer Trägerplatte kontaktiert und über einen ersten Spider mit den zugehörigen Lötflecken auf der Leiterplatte verbunden sind, **dadurch gekennzeichnet,** daß mit einer auf der Bausteinoberfläche gut wärmeleitend befestigten, allseits über die Bausteinkanten vorstehenden Membran (2), die ihrerseits an einer Kühlplatte (1) anliegt, ein Hohlraum (10) rund um den Baustein (4) gebildet ist, der mit einer Kühlflüssigkeit gefüllt ist, daß die Trägerplatte (6) als Rahmen (14) um den Baustein (4) ausgebildet ist, auf dessen Unterseite ein weiterer Spider (13) aufgebracht ist, daß in der Rahmenöffnung der Baustein (4) liegt, dessen Kontaktnocken (11) über Bonddrähte mit den einen Enden des weiteren Spiders (13) verbunden sind, dessen andere Enden mit dem ersten Spider (7) kontaktiert sind, daß der Zwischenraum zwischen Baustein (4) und rahmenförmiger Trägerplatte (6) flüssigkeitsdicht abgedichtet ist, daß die Membran (2) an der Außenkante des Rahmens (14) flüssigkeitsdicht befestigt ist so daß sich zwischen Membran (2) Bausteinkanten und rahmenförmiger Trägerplatte (14) der Hohlraum (10) bildet und daß zwischen Bausteinunterseite und Leiterplatte elastische Druckstücke (8) angeordnet sind.

2. Einbausystem nach einem der vorhergehenden Ansprüche, **dadurch gekennzeichnet,** daß die Trägerplatte (6) aus Keramik besteht.

3. Einbausystem nach Anspruch 2, **dadurch gekennzeichnet,** daß zwischen Bausteinoberfläche und Trägerplatte (6) eine Kühlfolie (5) angeordnet ist.
